# EUROPEAN PATENT APPLICATION

(11) **EP 1 814 371 A1**
(43) Date of publication of application: **01.08.2007**
(21) Application number: 07250254.5
(22) Date of filing: 22.01.2007
(51) Int. Cl.: H05K 3/34, H01L 23/488, H01L 23/367

(54) **Printed circuit board and method of use thereof**

(30) Priority: 26.01.2006 GB 0601543
(71) Applicant: Pace Micro Technology PLC, Shipley, West Yorkshire BD18 3LF (GB)
(72) Inventor: Skow, Paul, Leeds, LS13 3LL (GB); Belford, James William, Leeds, LS20 8HH (GB); McGonigal, Colin, Shipley, BD18 3LF (GB)
(74) Representative: Tomkinson, Alexandra

(57) **Abstract**

A printed circuit board (PCB) is provided. The PCB has at least a first surface and a second surface. One or more pre-defined areas defined on the first surface comprise a PCB plane (8) for the location of one or more electrical components thereon. One or more test pads (18) provided on the second surface allow electrical testing of the solder connection between said PCB and/or one or more electrical components. Two or more connectivity points (10) are provided on the first surface in each of said pre-defined areas. The connectivity points are a spaced distance apart and are substantially electrically isolated from each other before soldering. The connectivity points are capable of electrical connection in case of sufficient solder being present between the PCB and the electrical component.

## Description

This invention relates to a printed circuit board (PCB), and particularly but not necessarily exclusively to a PCB which allows the coverage of solder of an electronic component to the printed circuit board (PCB) to me measured, and a method of use thereof.

Conventional PCBs typically have an upper surface and a lower surface and one or more electrical components are located with said upper and/or lower surface in use. One or more PCB planes arc defined on said surfaces of said board provided typically provide areas of lower impedance between power and ground and to allow one or more electrical components to be connected to the same. For example, if the electrical component is likely to generate a large amount of heat during use and requires a connection to a PCB circuit (typically ground) to rapidly dissipate this heat, the electrical component is connected to a PCB plane on the board. It is important that adequate solder is provided between the PCB plane and an electrical component being connected thereto to ensure adequate heat dissipation from the component through the PCB in use. This heat dissipation is typically essential for the electrical component to function correctly in use.

One or more test pads are provided on PCBs, typically on a surface opposite to the surface on which the electrical components are attached, to allow electrical tests to be carried out on the PCB and/or electrical components. The test pads typically include an electrical test connection point in communication with a via which passes through the board to the opposite surface. Function tests are typically undertaken in respect of assembled PCBs using these test pads prior to shipping to ensure all components on the board are fully operational. Failure of one or more of the function tests can be as a result of inadequate levels of solder being provided between the PCB plane and an electrical component, thus causing overheating of the electrical component. However, conventionally, in order to test whether failure of the board is due to insufficient solder between the component and the PCB plane, an X-Ray typically has to be taken of the PCB. This is a time consuming and expensive method.

It is therefore an aim of the present invention to provide a PCB which allows the level or degree of solder contact between an electrical component and a surface or pre-defined area of said PCB to be determined.

It is a further aim of the present invention to provide a method which tests whether sufficient solder has been used between an electrical component and a pre-defined area of said PCB.

It is a yet further aim of the present invention to provide apparatus to allow the level or degree of solder contact between an electrical component and a surface or pre-defined area of said PCB to be determined.

According to a first aspect of the present invention there is provided a printed circuit board (PCB), said PCB having at least a first surface and a second surface, one or more pre-defined areas defined on said first surface having connection to or comprising a PCB plane for the location of one or more electrical components thereon in use, and one or more test pads provided on the second surface to allow electrical testing of said PCB and/or one or more electrical components located thereon, and wherein two or more connectivity points are provided on the first surface in each of said pre-defined areas, said connectivity points being a spaced distance apart and being substantially electrically isolated from each other in a first condition, the connectivity points capable of electrical connection in a second condition.

Thus, by providing a plurality of connectivity points or test points on a planed area of the PCB, such as a ground plane or ground slug, the level of solder used on the PCB area to allow attachment of an electrical component therewith can be determined by measuring the electrical connectivity between the connectivity points using the test pads on the opposite surface of the PCB. The introduction of the connectivity points on the board is a simple process and removes the requirement for the PCB to be x-rayed in order to determine whether adequate solder levels have been used between the electrical component and the PCB plane.

Preferably electrical conducting means are located between the two or more connectivity points to provide the second condition. The electrical conducting means is typically a sufficient amount or coverage of solder to form electrical connection between said spaced apart connectivity points. Thus, application of sufficient solder between the electrical component and the PCB plane provides the second condition wherein the connectivity points are no longer electrically isolated.

Preferably the number of connectivity points provided on the pre-defined area is sufficient to allow the level of solder connectivity to be determined between said area and said electrical component attached thereto in use. For example, five or more connectivity points are typically required on said pre-defined area in one embodiment.

Typically approximately 50% solder coverage is required between the electrical component and/or the two or more connectivity points and the pre-defined area to provide the second condition.

Preferably the electrical component is an integrated circuit (IC) in one example. The IC generates a large amount of heat in use which needs to be dissipated rapidly through the PCB to ensure adequate functioning of the IC.

Preferably each connectivity point provided on the pre-defined area includes an inner portion and an outer portion. The inner and outer portions of each connectivity point are preferably substantially electrically isolated in the first condition. A small gap or space is provided between said inner and outer portions and said gap provides said electrical isolation in said first condition. The gap is bridged by the electrical conducting means or solder when adequate solder is used between the component and the pre-defined area in use, thereby allowing electrical connection between the inner and outer portions of said connectivity points. Thus, substantially no solder resist is located in said gap between said inner and outer portions on said PCB plane of said PCB.

Preferably an inner portion of each connectivity point on the first surface communicates with a test pad on the opposite or second surface via at least one via. Thus, each inner portion of each connectivity point communicates with a separate test pad.

Preferably the outer portion of each connectivity point is typically electrically connected or connectable to at least one other connectivity point in said pre-defined area, and further preferably to all of said other connectivity points in said area in the first and/or second condition. This allows the electrical conductivity of any connectivity point on the PCB to be tested relative to any other connectivity point in the pre-defined area.

Thus, in the first condition, the inner portion of each point communicates with a test pad and the outer portion of each point communicates with at least one other outer portion in the pre-defined area. Electrical connectivity of the outer portions cannot be measured since the inner and outer portion within each connectivity point are electrically isolated in the first condition and thus the outer portion is not in communication with a test pad. However, in the second condition, solder bridges the gap between the outer and inner portions of a connectivity point, thereby allowing electrical conduction between the inner and outer portions and thus electrical conductivity to be measured between the outer portion and the test pad associated with the inner portion.

The connectivity points can be any suitable shape, such as circular, square and/or the like.

Preferably the inner and/or outer portions are substantially continuous in form.

Further preferably the inner and /or outer portions have a space located therein/therebetween. For example, both the inner and outer portions can be substantially annular in form.

Test pads arc conventionally provided on PCBs and are normally geographically distributed evenly across the board to allow electrical testing of components provided on the board to be undertaken. A via typically connects each test pad to a connectivity point and said test pad and said connectivity point are preferably located in substantial vertical alignment on said opposing surfaces of said PCB (i.e. each via is arranged substantially perpendicularly to the first and second surfaces of the board).

In one embodiment, the electrical testing undertaken using the test pads to determine the conductivity between the connectivity points on the opposite surface is typically a "bed of nails" in-circuit test (ICT).

According to a second aspect of the present invention there is provided method for determining the amount of solder provided between two connectivity points in a pre-defined area of a PCB, said PCB having at least a first surface and a second surface, the pre-defined area defined on said first surface and having connection to or comprising a PCB plane for the location of one or more electrical components thereon in use, and one or more test pads provided on the second surface to allow electrical testing of said PCB and/or one or more electrical components located thereon, and wherein the two or more connectivity points are provided on the first surface in each of said pre-defined areas, said connectivity points being a spaced distance apart and substantially electrically isolated from each other in a first condition, the connectivity points capable of electrical connection in a second condition upon application of sufficient solder and said method including the step of testing the electrical connectivity between said connectivity points using said test pads.

According to a further aspect of the present invention there is provided solder test apparatus, said apparatus including a PCB and electrical conductivity test equipment.

According to a yet further aspect of the present invention there is provided a printed circuit board (PCB), said PCB having at least a first surface and a second surface, one or more pre-defined areas defined on said first surface having connection to or comprising a PCB plane for the location of one or more electrical components thereon in use, and one or more test pads provided on the second surface to allow electrical testing of said PCB and/or one or more electrical components located thereon, and wherein two or more connectivity points are provided on the first surface in each of said prc-dcfincd areas, said connectivity points being a spaced distance apart and each point including an inner portion and an outer portion, the inner portion communicating with a test pad and being substantially electrically isolated from the outer portion, the outer portion of two or more connectivity points being electrically connected in the first condition but being substantially electrically isolated from a test pad, the inner and outer portions of the connectivity points capable of electrical connection in a second condition upon application of sufficient solder between said inner and outer portions.

Embodiments of the present invention will now be described with reference to the accompanying figures, wherein:

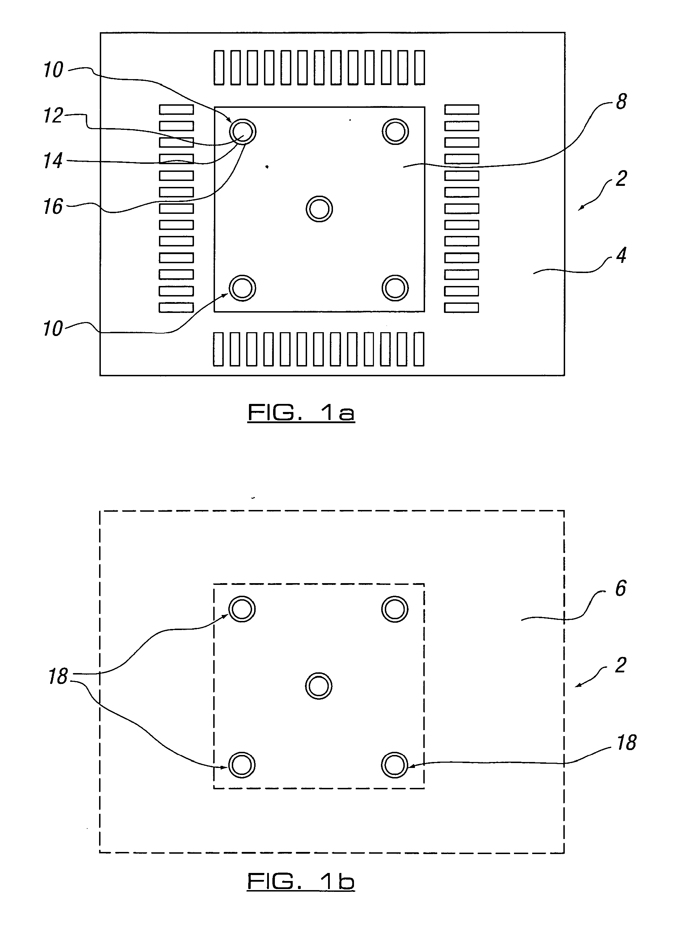

Figures 1a and 1b illustrate an upper and lower surface of a PCB according to the present invention;
Figure 2 illustrates means for testing the level of solvent provided on the upper surface of the PCB in figure 1a using the lower surface of the PCB in figure 1b;

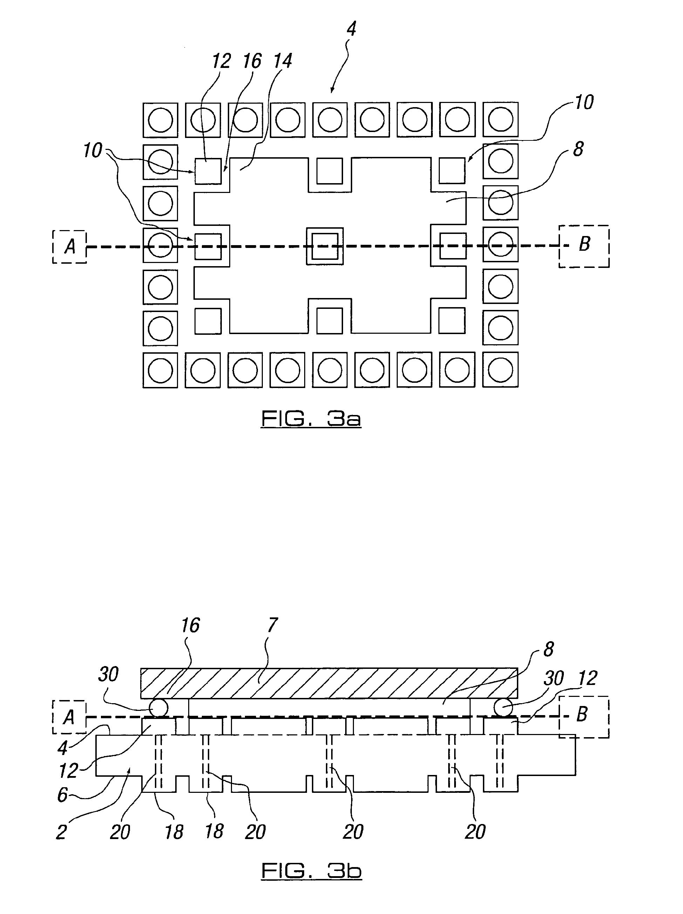

Figures 3a and 3b illustrate a plan view of an upper surface of a further PCB according to the present invention and a cross sectional view taken through lines A-B in figure 3a respectively.

Referring to the figures, there is illustrated a PCB 2 having an upper surface 4 and a lower surface 6. A PCB plane 8 is provided on upper surface 4 and an electrical component in the form of an integrated circuit (IC) 7 requiring connection to PCB is located on said PCB plane 8 in use of said PCB.

A plurality of connectivity points 10 are provided at spaced apart locations on upper surface 4 of PCB plane 8 and, prior to assembly of the electrical component with said PCB plane 8, each connectivity point is in electrical isolation from the other connectivity points.

Each connectivity point 10 includes an inner portion 12, an outer portion 14 and a gap 16 defined between said inner and outer portion. The gap has substantially no solder resist material provided thereon to allow solder to pass between said gap in use of the assembled PCB. The outer portions 14 of all the connectivity points 10 are electrically connected together.

A plurality of test pads 18 are provided on lower surface 6 of PCB 2 and vias 20 are provided between said test pads and the connectivity points 10 on the opposite surface of the PCB. The vias allow electrical communication or connectivity between the test pads 18 and the connectivity points 10 on the PCB plane 8 in use. More specifically, the via connects the inner portion 12 of the connectivity point to the test pad. As such, in a first condition wherein no solder or insufficient solder is present in the pre-defined area. A test pad communicates with an inner portion of a connectivity point but the test pad is isolated from the outer portion of the connectivity point due to the gap between the inner and outer portions. As such, despite the outer portions of two or more connectivity points being electrically connected or connectable together, the connectivity cannot be measured due to the test pads not being in communication with the outer portion. When solder fills the gap between the inner and outer portions of connectivity points, electrical connection between the test pad and the outer portion is now made and thus the connectivity of two or more connectivity points can be measured via the electrical connections of the outer portions of said points.

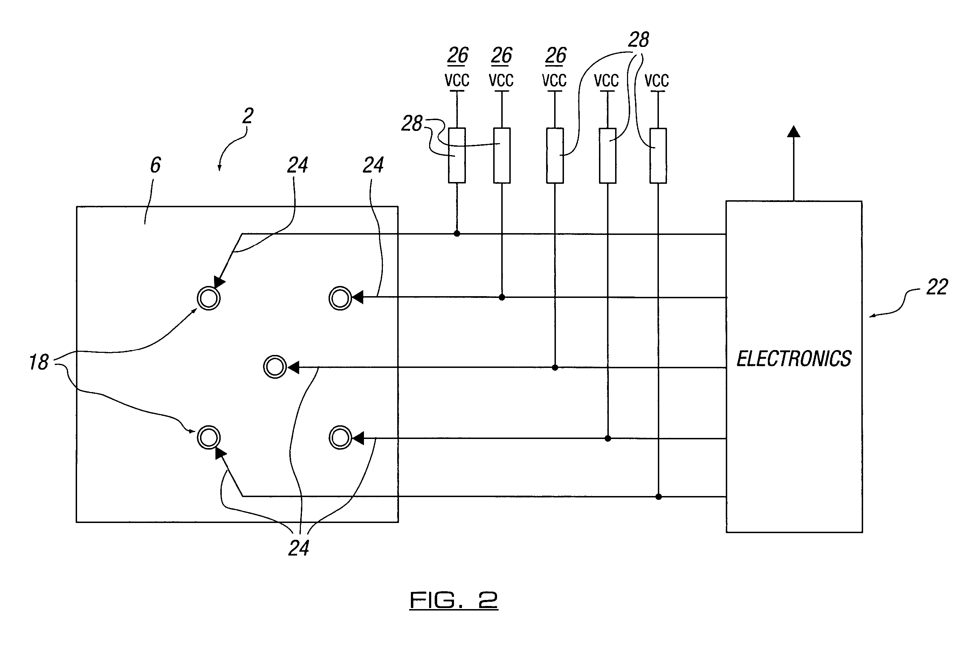

In order to test whether sufficient levels of solder have been provided between IC 7 and PCB plane 8, and thus determine whether adequate heat dissipation can take place between said IC and PCB in normal use of the PCB, electrical test circuitry 22 is connected to test pads 18 in a conventional manner as shown in figure 2. The conventional electrical test circuitry 22 typically performs a "bed of nails" in-circuit test (ICT) which brings a plurality of electrical contacts, such as pins 24 into contact with test pads 18. The pins 24 are in turn connected to voltage supplies 26 and resistors 28 are located in said circuitry.

If adequate solder has been provided between the IC 7 and the connectivity points 10, each connectivity point should be capable of electrical connection to another connectivity point 10 on said PCB plane 8. Thus, when an electrical current is applied through the PCB and the solder 30 provided between the IC 7 and PCB plane 8 heats up, the solder bridges the gap 16 between the inner and outer portions 14 of the connectivity points 10. Since the outer portions 14 of all the connectivity points are electrically connected together, bridging of gap 16 allows electrical connectivity to be provided between via 20 connecting inner portion 12 of a connectivity point 10 to a test pad 18 located on the opposite surface of PCB 2. This electrical connectivity is measured using circuitry 22 via connection pins 24. If the gap is bridged by solder and the connectivity point 10 is no longer isolated from outer portion 14, the resistance through resistor 28 goes to a closed circuit or very low resistance. If the gap is not bridged by solder, the connectivity point 10 will still be isolated from outer portion 14 and thus the other connectivity points 10 and the resistance through resistor 28 will remain high.

Thus, it can be seen that apparatus is provided which allows testing of whether there is sufficient solder provided between an electrical component and a PCB plane on a PCB without the use of expensive test apparatus, such as X-ray apparatus.

## Claims

1. A printed circuit board (PCB), said PCB having at least a first surface and a second surface, one or more pre-defined areas defined on said first surface having connection to or comprising a PCB plane for the location of one or more electrical components thereon in use, and one or more test pads provided on the second surface to allow electrical testing of said PCB and/or one or more electrical components located thereon, and wherein two or more connectivity points are provided on the first surface in each of said pre-defined areas, said connectivity points being a spaced distance apart and being substantially electrically isolated from each other in a first condition, the connectivity points capable of electrical connection in a second condition.

2. A PCB according to claim 1 wherein electrical conducting means are located between the connectivity points to provide the second condition.

3. A PCB according to claim 2 wherein the electrical conducting means includes sufficient solder to form electrical connection between the two or more connectivity points.

4. A PCB according to claim 1 wherein each connectivity point includes an inner portion and an outer portion, the inner and outer portions being substantially electrically isolated in the first condition.

5. A PCB according to claim 4 wherein electrical isolation between the inner and outer portions is provided by a gap or space.

6. A PCB according to claim 5 wherein electrical conducting means are located between the inner and outer portions to fill or cross the gap in the second condition.

7. A PCB according to claim 6 wherein the electrical conducting means includes sufficient solder to form electrical connection between the inner and outer portions.

8. A PCB according to claim 5 wherein the space or gap is substantially free of solder resist material or a solder resist component.

9. A PCB according to claim 4 wherein each of the inner and outer portions is substantially continuous in form.

10. A PCB according to claim 1 wherein the number of connectivity points provided in a pre-defined area is sufficient to allow the level of solder connectivity to be determined in said area.

11. A PCB according to claim 1 wherein five or more connectivity points are provided in a pre-defined area.

12. A PCB according to claim 3 wherein at least 50% solder coverage of the pre-defined area is required to allow electrical connection between two or more connectivity points in the second condition.

13. A PCB according to claim 1 wherein the electrical component located on the board is an integrated circuit (IC).

14. A PCB according to claim 1 wherein one or more vias are provided between a connectivity point on the first surface and a test pad provided on the second surface.

15. A PCB according to claim 14 wherein a via is provided between the inner portion of the connectivity point on the first surface and a first test pad on the second surface.

16. A PCB according to claim 14 wherein the vias are arranged substantially perpendicularly to the first and second surfaces of the board.

17. A PCB according to claim 1 wherein a "bed of nails" in-circuit test (ICT) is connected to the test pads of the PCB to determine the level of conductivity between two or more conductivity points.

18. A PCB according to claim 4 wherein the outer portions of each connectivity point in a pre-defined area are electrically connected together in the first and/or second condition.

19. Solder test apparatus including a PCB according to claim 1 and electrical connectivity test equipment.

20. A method for determining the amount of solder provided between two connectivity points in a pre-defined area of a PCB, said PCB having at least a first surface and a second surface, the pre-defined area defined on said first surface and having connection to or comprising a PCB plane for the location of one or more electrical components thereon in use, and one or more test pads provided on the second surface to allow electrical testing of said PCB and/or one or more electrical components located thereon, and wherein the two or more connectivity points are provided on the first surface in each of said pre-defined areas, said connectivity points being a spaced distance apart and substantially electrically isolated from each other in a first condition, the connectivity points capable of electrical connection in a second condition upon application of sufficient solder and said method including the step of testing the electrical connectivity between said connectivity points using said test pads.

21. A printed circuit board (PCB), said PCB having at least a first surface and a second surface, one or more pre-defined areas defined on said first surface having connection to or comprising a PCB plane for the location of one or more electrical components thereon in use, and one or more test pads provided on the second surface to allow electrical testing of said PCB and/or one or more electrical components located thereon, and wherein two or more connectivity points are provided on the first surface in each of said pre-defined areas, said connectivity points being a spaced distance apart and each point including an inner portion and an outer portion, the inner portion communicating with a test pad and being substantially electrically isolated from the outer portion, the outer portion of two or more connectivity points being electrically connected in the first condition but being substantially electrically isolated from a test pad, the inner and outer portions of the connectivity points capable of electrical connection in a second condition upon application of sufficient solder between said inner and Outer portions.
